# EUROPEAN PATENT APPLICATION

(11) **EP 4 435 433 A1**
(43) Date of publication of application: **25.09.2024**
(21) Application number: 23162956.9
(22) Date of filing: 20.03.2023
(51) Int. Cl.: G01R 1/20

(54) **BUSBAR ASSEMBLY FOR MEASURING AN ELECTRIC CURRENT BETWEEN TWO BUSBARS**

(71) Applicant: TE Connectivity Solutions GmbH, 8200 Schaffhausen (CH)
(72) Inventor: SCHERNER, Simon, 8200 Schaffhausen (CH); ZAWADZKY, Peter, 8200 Schaffhausen (CH)
(74) Representative: Grünecker Patent- und Rechtsanwälte PartG mbB

(57) **Abstract**

The invention relates to a busbar assembly (1) configured to measure an electric current between two busbars (3, 5). In order to provide a compact and reliable assembly, the busbar assembly (1) comprises a first busbar (3) with at least one flat side (7, 9), a second busbar (5) and a shunt resistor element (15), wherein, in an assembled state (2), the shunt resistor element (15) abuts the flat side (7, 9) of the first busbar (3) and is in electrical contact with the second busbar (5).

## Description

The invention relates to a busbar assembly configured to measure an electric current between two busbars.

Measuring an electric current between two busbars may be necessary to avoid excessive currents and overheating of the busbars. Particularly, this may be of advantage in electric vehicles, in instances where busbars connect the main battery with the electric drive or where busbars connect the battery with charging equipment.

It is the object of the invention to provide means for measuring the electric current between two busbars in a simple, reliable, accurate and compact manner.

This object is achieved with a busbar assembly comprising a first busbar with at least one flat side, a second busbar and a shunt resistor element, wherein, in an assembled state of the busbar assembly, the shunt resistor element abuts the flat side of the first busbar and is in electrical contact with the second busbar.

The flat side of the first busbar preferably abuts the shunt resistor element directly, in particular without intermediate layers. Thereby, intermediate elements, in particular conducting elements for electrically connecting the busbar with the shunt resistor element can be eliminated. The surface of the flat side of the first busbar and the surface of the shunt resistor element are preferably in direct contact with each other.

The shunt resistor element is preferably a low resistance resistor element with a very low temperature coefficient. The shunt resistor element preferably comprises manganese. The shunt resistor element is preferably a monolithic piece made of an alloy comprising manganese. Preferably, the shunt resistor element is formed by an alloy containing 80-85% copper, 10-20% manganese and 1-5% nickel. However, other compositions are also possible. Further, the shunt resistor element may comprise a coating.

As mentioned before, additional layers or conducting elements are preferably omitted. Thus, the shunt resistor element is preferably made from a homogenous material comprising manganese. Instead of manganese, the shunt resistor element may comprise other alternative materials.

The first busbar is preferably strip-shaped, at least in the region where it abuts the shunt resistor element. Thus, the busbar may have two flat sides opposite each other.

In the following, further improvements of the invention are described. The additional improvements may be combined independently of each other, depending on whether a particular advantage of a particular improvement is needed in a specific application.

According to a first advantageous improvement, the first busbar, the second busbar and the shunt resistor element preferably overlap in a direction perpendicular to the flat side of the first busbar, particularly in the assembled state. Thereby, a compact arrangement can be achieved.

The busbar assembly preferably has a current flow direction extending through the shunt resistor element perpendicular to the flat side of the first busbar. Thereby, a short passage for the electric current is possible. Preferably, the shunt resistor element is in electric contact with two of its sides in the assembled state, the two sides being arranged opposite each other perpendicular to the flat side of the first busbar.

According to another advantageous improvement, the second busbar has at least one flat side and the shunt resistor element abuts the flat side of the second busbar in the assembled state.

In order to make the busbar assembly more compact, the first busbar, the second busbar and the shunt resistor element together form a sandwich structure in the assembled state. In particular, a sandwich structure made from the following three layers: first busbar, second busbar and shunt resistor element. Preferably, no further intermediate layers are present.

The at least one shunt resistor element and/or at least one of the busbars may have a coating. The coating may provide protection against oxidation and/or corrosion. Further, the coating may reduce the contact resistance of the various elements, which may in particular be important in a screw and/or clamp connection. The coating may form a part of the corresponding element. Thus, the coating is not an additional layer that may be omitted by the invention as described above.

In order to improve the conductivity between the busbars and the shunt resistor element, one flat side of the shunt resistor element may lie flat against the flat side of the first busbar and the opposing side of the shunt resistor element lies flat against the flat side of the second busbar.

The shunt resistor element preferably has an overall disk shape. The shunt resistor element is thus preferably flat. In the assembled state, the two opposing sides of the disk-shaped shunt resistor element are preferably connected to flat sides of the busbar by directly abutting these.

The shunt resistor element may have any suitable shape. Preferably, the shunt resistor element has an overall flat shape. Just by way of example, the shunt resistor element may have a ring shape, in particular the shape of a ring disk. Other shapes are also possible, for example a rectangular, a square or another polygonal shape.

In the assembled state, the shunt resistor element is preferably connected via at least one screw connection to at least one of the busbars. The screw connection may provide a simple way of forming a press-connection between the two busbars and the shunt resistor element.

A compact and simple busbar assembly may be achieved when, in the assembled state, a screw bolt extends through the first busbar, the second busbar and the shunt resistor element. The screw bolt may be fixated with a screw nut. The head of the screw and the screw nut may be arranged on opposite ends of the screw bolt with the two busbars and the shunt resistor element forming a sandwich structure therebetween. In particular, in this arrangement, the shunt resistor element preferably has a ring shape, in particular a ring disk shape.

Alternatively or additionally to the screw connection, the shunt resistor element may be connected via at least one weld connection or at least one solder connection to at least one of the busbars.

In order to measure the electric current with the shunt resistor element, the shunt resistor element is usually in electric contact with two measurement contacts, preferably at two opposing sides. If it is not possible to arrange the two measurement contacts on two opposing sides of the shunt resistor element, it can be beneficial to space the two measurement contacts apart from each other along a current flow direction along which electric current flows through the shunt resistor element. In order to measure the electric current, a simple voltage measurement can be performed between the two measurement contacts. In particular, the measurement contacts may be used for measuring a voltage drop between their corresponding positions. When the electrical resistance of the shunt resistor element is known, the electric current can easily be calculated by the known relation between current, voltage and resistance.

In order to improve the current measurement, at least one measurement contact may be embedded in the shunt resistor element, in particular in the surface thereof. Due to this arrangement, disturbances in the current measurement can be avoided. As is known, materials, such as copper, show a strong temperature dependence in their electrical resistance. As the busbars are usually made from copper or a copper alloy, the material of the busbars is affected by the temperature dependency. The busbars usually heat up at large currents due to their electrical resistance. In order to provide a precise current measurement, temperature dependencies should be avoided. Thus, embedding at least one measurement contact directly in the shunt resistor or the surface thereof, is advantageous over an arrangement in which the measurement contact is embedded in the busbar, even if it is close to the shunt resistor element.

The shunt resistor element may be provided with at least one longitudinal groove that forms a receptacle for a measurement contact in its surface. Preferably, the shunt resistor element is provided with two longitudinal grooves, wherein each of the two flat sides is provided with one of the grooves. In the alternative to a groove, the shunt resistor element may be provided with other structures, in particular holes, for receiving the measurement contacts

As an alternative to an arrangement in which at least one of the measurement contacts is embedded in the shunt resistor element, at least one measurement contact may abut the shunt resistor element in the assembled state.

In particular, in a case in which it is not possible to embed the at least one measurement contact in the shunt resistor element, the at least one measurement contact may be electrically connected to one of the busbars, but preferably at the same electric potential as the shunt resistor element.

At least one measurement contact may be formed as a washer and be located, in particular pressed, between the shunt resistor element and at least one of the busbars in the assembled state. This arrangement may, in particular, be implemented with a screw connection between the two busbars and the shunt resistor element.

In the following, the invention and its improvements are described in greater detail using exemplary embodiments and with reference to the drawings. As described above, the various features shown in the embodiments may be used independently of each other in specific applications.

In the following figures, elements having the same function and/or the same structure will be referenced by the same reference signs.

In the drawings:
- Fig. 1: shows a first embodiment of the busbar assembly;
- Fig. 2: shows a second embodiment of the busbar assembly;
- Fig. 3: shows a third embodiment of the busbar assembly;
- Figs. 4 to 8: show a fourth embodiment of the busbar assembly;
- Fig. 9: shows a fifth embodiment of the busbar assembly;
- Fig. 10: shows a sixth embodiment of the busbar assembly;
- Fig. 11: shows a seventh embodiment of the busbar assembly;
- Fig. 12: shows an eighth embodiment of the busbar assembly;
- Figs. 13 to 14: show a ninth embodiment of the busbar assembly; and
- Figs. 15 to 16: show a tenth embodiment of the busbar assembly.

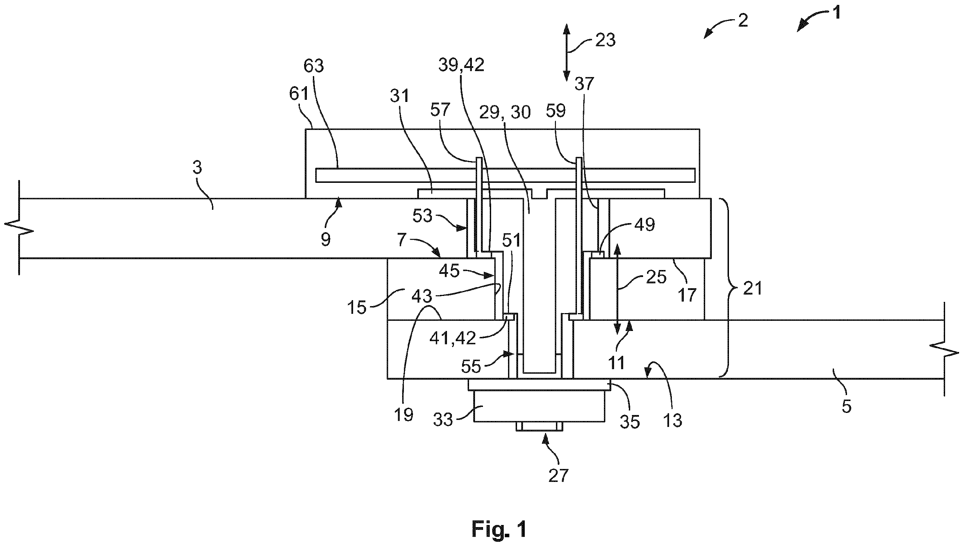

In the following, a first embodiment of the busbar assembly 1 in an assembled state 2 is described with respect to Fig. 1. The figure is not true to scale and serves only for explanatory reasons.

The busbar assembly 1 comprises a first busbar 3 and a second busbar 5. In an assembled state 2, the busbars 3 and 5 are electrically connected with each other. The busbars 3 and 5 may, in particular be part of an electric circuit in an electric vehicle. However, this is not mandatory. Preferably, both busbars have rectangular cross sections (not shown).

The first busbar 3 has at least one flat side 7. In case of the rectangular cross section, the first busbar 3 further has a second flat side 9 opposite to the flat side 7. However, this is not mandatory. The first busbar 3 may, alternatively, have a different cross section. Just by way of example, the busbar 3, and the busbar 5, may have half-round or polygonal cross sections.

The two busbars 3 and 5 are preferably strip-shaped.

Preferably, the second busbar 5 has a flat side 11 and a second flat side 13 opposite to the first flat side 11.

The assembly 1 further comprises a shunt resistor element 15. The shunt resistor element 15 is preferably made from a low resistance material, in particular an alloy comprising manganese.

The shunt resistor element 15 is preferably made monolithically and homogeneously from low resistance material. In other words, the shunt resistor element 15 preferably does not comprise additional layers or current conducting elements intended to conduct currents from the busbars 3, 5 to low resistance materials. However, this does not exclude a shunt resistor element 15 being provided with at least one coating.

The shunt resistor element 15 preferably has an overall flat shape, in particular a disk shape. The shunt resistor element 15 of the first embodiment of the busbar assembly 1 may have an overall ring disk shape or a rectangular disk shape.

The shunt resistor element 15 has two opposing flat sides, a first flat side 17 and a second flat side 19. The two flat sides 17 and 19 are arranged opposite each other.

The first flat side 17 directly abuts the flat side 7 of the first busbar 3. The second flat side 19 of the shunt resistor element 15 directly abuts the flat side 11 of the second busbar 5.

Due to the abutment of the two busbars 3 and 5 and the shunt resistor element 15, the first busbar 3 is electrically connected to the second busbar 5 via the shunt resistor element 15. The first busbar 3, the shunt resistor element 15 and the second busbar 5 together form a sandwich structure 21. Preferably, there are no intermediate layers between the busbars and the shunt resistor element 15.

In a direction 23 perpendicular to the flat side 7 of the first busbar 3, the two busbars 3 and 5 and the shunt resistor element 15 preferably overlap. A current flow direction 25 preferably extends through the shunt resistor element 15 perpendicular to the flat side 7 of the first busbar 3 and thus parallel with the direction 23.

Preferably, the flat side 7 of the first busbar 3, both flat sides 17 and 19 of the shunt resistor element 15 and the flat side 19 of the second busbar 5 extend parallel with each other and perpendicular to the direction 23.

The shunt resistor element 15 is connected to the busbars 3 and 5 via a screw connection 27. In particular, the shunt resistor element 15 is pressed between the two busbars 3 and 5 by the screw connection 27.

In order to form a screw connection 27, a screw 29 is provided. The screw 29 has a screw bolt 30 and a bottom plate 31. The screw bolt 30 extends through the first busbar 3, the shunt resistor element 15 and the second busbar 5, whereby the bottom plate 31 abuts the second flat side of the first busbar 3.

At the second flat side 13 of the second busbar 5, a screw nut 33 secures the screw 29. A washer 35 may be placed between the screw nut 33 and the second busbar 5.

In order to avoid an electric current unintentionally flowing through the screw 29 and thereby bypassing the shunt resistor element 15, an insulation structure 37, in particular in the form of a shell, may be present between the screw 29 and the conducting elements of the assembly 1. Preferably, the bottom plate 31 is made from or coated with an electrically insulating material.

In order to make electric contact with the shunt resistor element 15 for the purpose of measuring the flow of electric current, two measurement contacts 39 and 41 are provided, which are in electric contact with the shunt resistor element 15.

A first measurement contact 39 is in contact with the first flat side 17 of the shunt resistor element 15 and a second measurement contact 41 is in contact with the shunt resistor element 15 close to the second flat side 19.

Alternatively, the second measurement contact 41 may be in contact with the first flat side 11 of the second busbar 5 in close vicinity to the shunt resistor element 15 and, in particular, at the same electric potential as the second flat side 19 of the shunt resistor element 15.

Preferably, the second measurement contact 41 abuts the shunt resistor element 15 on an inner side 43 of a through-hole 45 through which the screw bolt 30 extends.

In the first embodiment, the measurement contacts 39 and 41 may be formed as washers 42 that may be pressed by the insulating structure 37 against the busbars 3 and 5 against the shunt resistor element 15.

Preferably, the insulation structure 37 has a first step 49 adapted to press the first measurement contact 39 against the shunt resistor element 15 and a second step 51 adapted to press the second measurement contact 41 against the second busbar 5.

Thus, the first busbar 3 preferably has a through-hole 53 whose diameter is large enough to receive the first measurement contact 39 and the first step 49 of the insulating structure 37. The through-hole 45 in the shunt resistor element 15 is preferably large enough to receive the second measurement contact 41 and the second step 51 of the insulating structure 37.

A through-hole 55 in the second busbar 5 is preferably large enough to receive the screw bolt 30, but small enough to allow the second measurement contact 41 to lie against the first flat side 11.

In other words, the through-hole 45 has a smaller diameter than the through-hole 53 and the through-hole 55 has a smaller diameter than the through-hole 45.

Electric connection lines 57 and 59 may be in contact with measurement contacts 39 and 41. The electric connection lines 57, 59 may be guided out of the sandwich structure 21 and extend into a housing 61. The housing 61 may contain a circuit board 63, to which the electric connection lines 57 and 59 are connected.

The circuit board 63 may comprise electronic components for controlling the measurement contacts 39 and 41 and for calculating the electric current flowing through the shunt resistor element 15. The electric connection lines 57 and 59 may be part of a lead frame, which may be arranged inside the housing 61.

Instead of being pressed against the shunt resistor element 15 and the second busbar 5, the measurement contacts 39 and 41 may alternatively be embedded in the shunt resistor element 15.

Alternative to or additional to the screw connection 27, at least one of the busbars 3 or 5 may be connected to the shunt resistor element 15 by at least one weld connection or at least one solder connection.

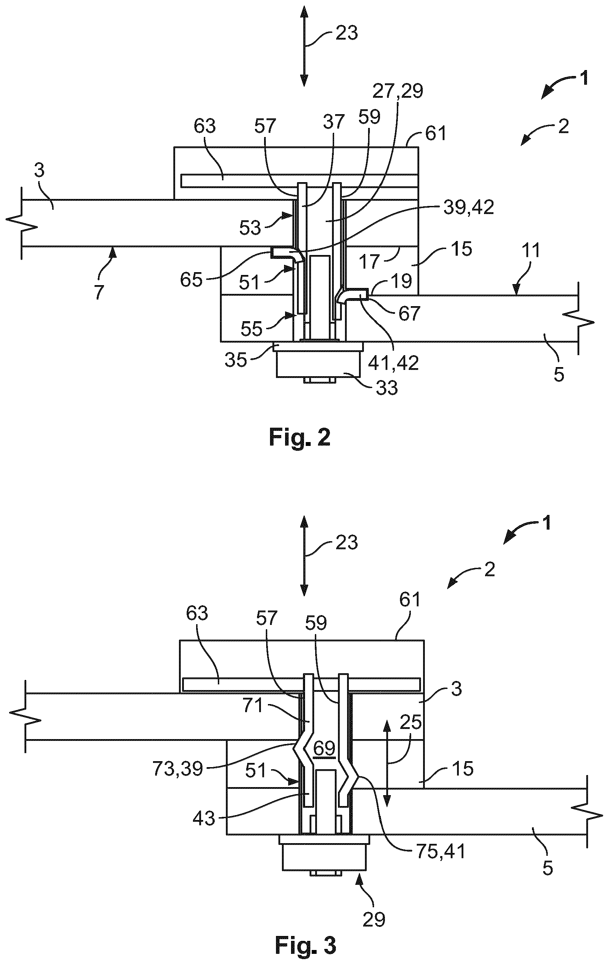

In the following, a second preferred embodiment of the busbar assembly 1 according to the invention is described with respect to Figure 2. For the sake of brevity, only the differences to the first embodiment are described in detail.

Instead of using through-holes with different diameters and a stepped insulation structure 37, the through-holes 53 of the first busbar, 51 of the shunt resistor element 15 and 55 of the second busbar 55 may have similar diameters. The insulating structure 37 may have a stepped shape, but this is not mandatory.

The measurement contacts 39 and 41 are preferably formed as washers 42, most preferably spring washers and are arranged between the shunt resistor element 15 and the corresponding busbar 3 or 5. In order to provide sufficient space for the measurement contacts 39 and 41, flat sides 17 and 19 of the shunt resistor element 15 may be provided with receptacles 65 and 67 for receiving the corresponding measurement contacts 39 and 41.

A third embodiment of a busbar assembly 1 according to the invention, is now described with respect to Figure 3.

The arrangement of the busbar 3, the shunt resistor element 15 and the second busbar 5 may be similar to the arrangement described with respect to Figure 2.

The through-holes 53, 51 and 55 of the first busbar 3, the shunt resistor element 15 and the second busbar5 may be aligned with each other and have similar diameters. Thus, a receiving channel 69 may be formed for receiving a plug element 71 that is configured to contact the inner side 43 of the shunt resistor element 15 in the through-hole 51.

The plug element 71 may be provided with two elastic contact springs 73 and 75, which are spaced apart from each other in the direction 23. Thus, each of the contact springs 73 and 75 is in contact with the shunt resistor element 15 at different positions along the current flow direction 25.

The first contact springs 73 may correspond to the first measurement contact 39 and the second contact spring 75 may correspond to the second measurement contact 41.

In order to fixate the plug element 71 in its place, a screw 29 may be provided which is configured to be fixated to the plug element 71. The plug element 71 can, on the side opposite to the screw 29, be fixated in a housing 61. Electric connection lines 57 and 59 may be provided to connect the contact springs 73 and 75 to a circuit board 63 in the housing 61.

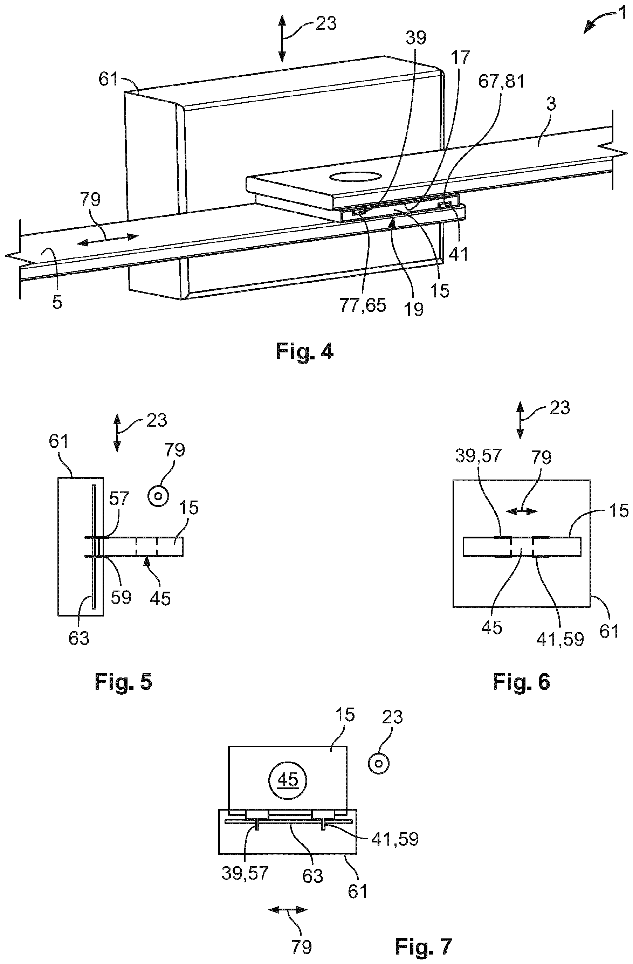

In the following, a fourth preferred embodiment of the busbar assembly 1 according to the invention is described with respect to Figures 4 to 8.

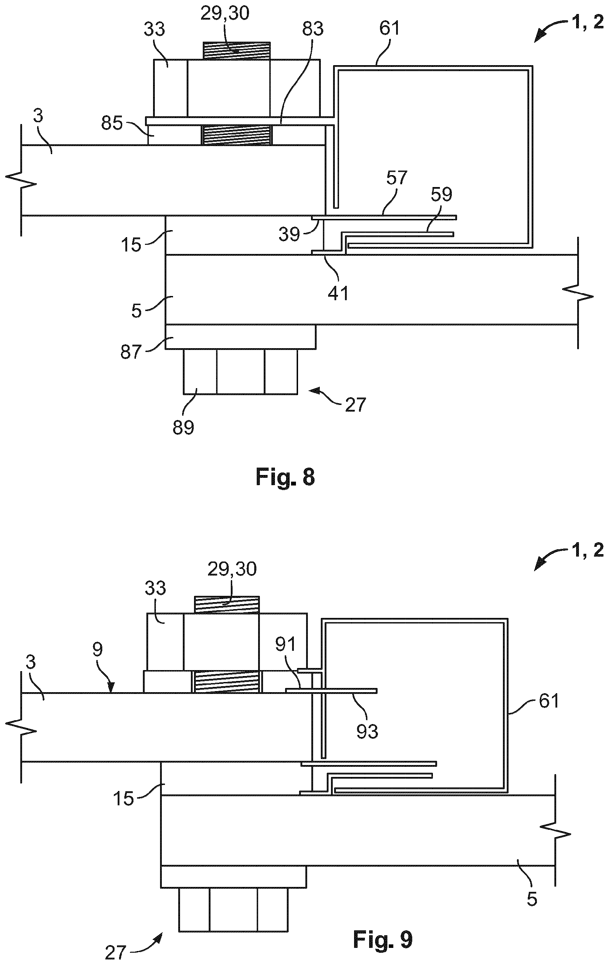

Figure 4 shows a perspective view of the busbar assembly 1, Figures 5 to 7 show schematic perspective views from different directions and Figure 8 shows the assembly 1 with an additional screw connection. Again, only the differences to the embodiment described before are mentioned in detail.

The flat busbars 3 and 5 directly abut the shunt resistor element 15. The shunt resistor element 15 is provided with two receptacles 65 and 67 for receiving resistance measurement contacts 39 and 41.

The first flat side 17 of the shunt resistor element 15 is provided with a longitudinal groove 77 that forms the receptacle 65. The longitudinal groove 77 extends perpendicular to the direction 23 and perpendicular to a longitudinal direction 79 of the busbars 3 and 5.

A second longitudinal groove 81 is formed in the second flat side 19 of the shunt resistor element 15 and forms the receptacle 67 for measurement contact 41. The longitudinal groove 81 extends parallel to the longitudinal groove 77.

Each of the measurement contacts 39 and 41 may be formed as a single piece together with corresponding electric connection line 57 or 59.

The measurement contacts 39 and 41 may be welded or soldered to the shunt resistor element 15 in order to be fixated in their corresponding receptacles 65 and 67.

In Figure 8, the fourth embodiment of the busbar assembly 1 is shown in the assembled state 2, in which the first busbar 3, the shunt resistor element 15 and the second busbar 5 are secured to each other via screw connection 27.

The screw connection 27 may be similar to the ones described with respect to the embodiments mentioned above. The housing 61 may comprise a fixation element 83 that can be fixated by the screw connection 27 in a manner similar to the other elements of the assembly 1.

In order to avoid electric current flowing through screw bolt 30, electrically insulating washers 85 and 87 may be arranged between the screw head 89 and the second busbar 5, and also between the screw nut 33 and the first busbar 3.

A fifth embodiment of the busbar assembly 1 shown in Figure 9 is essentially similar to the fourth embodiment described in Figures 4 to 8, but further comprises an additional measurement contact 91 that is arranged on the second flat side 9 of the first busbar 3.

The additional measurement contact 91 may be brought into contact via an additional electrical connection line 93 extending into the housing 61. The additional measurement contact 91 may be formed by a cable lug (not shown).

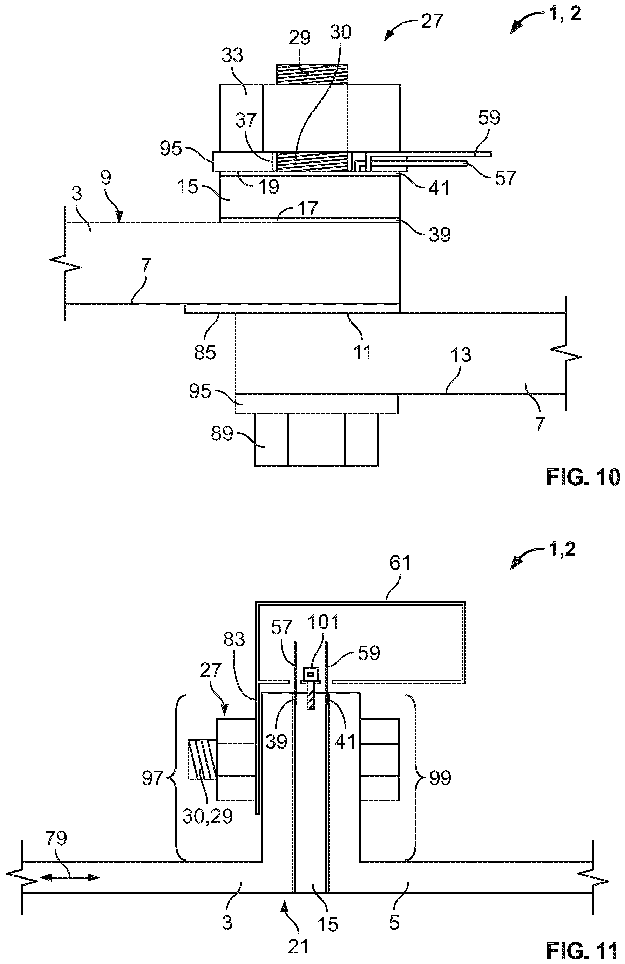

A sixth advantageous embodiment of the busbar assembly 1 according to the invention shown in Figure 10 differs from the embodiments described above, in that the shunt resistor element 15 is not arranged between the two busbars 3 and 5.

Here, the shunt resistor element 15 abuts the second flat side 9 of the first busbar 3, while the flat side 7 of the first busbar 3 is orientated towards the first flat side 11 of the second busbar 7, but is not in electric contact with the latter.

Instead, an insulating washer 85 is arranged between the two busbars 3 and 7, thereby preventing electric current from flowing directly from the first busbar 3 to the second busbar 5 and vice versa.

The shunt resistor element 15 directly abuts the second flat side 9 of the first busbar 3 with its first flat side 17. An electrically conductive washer 95, preferably made from copper or a copper alloy, is arranged between the second flat side 19 of the shunt resistor element 15 and screw nut 33.

The first busbar 3 abuts the insulating washer 85 with its flat side 7. Opposite to the first busbar 3, the insulating washer 85 abuts the first flat side 11 of the second busbar 7.

The second busbar 7 abuts another electrically conductive washer 95 with its second flat side 13. The electrically conductive washer 95 is followed by a screw head 89. Thus, electric current may flow from the first busbar 3 through the shunt resistor element 15 and the electrically conductive washer 95 into the screw nut 33.

The screw bolt 30 acts as electrical conductor to the screw head 89. From there, the current may flow through an electrically conductive washer 95 that is arranged between the screw head 89 and the second busbar 7 into the second busbar 7. Apparently, the current may flow in the reverse direction as well. In order to prevent a short circuit, an insulating structure 37 may be placed between the screw bolt 30 and the bus bars 3 and 5.

A seventh embodiment of the busbar assembly 1 is shown in Figure 11.

In the previous embodiments of the busbar assembly 1, the two busbars 3 and 5 extend continuously along the longitudinal direction 79. In other words, one busbar serves as the continuation of the other busbar along the longitudinal direction 79. Due to the shunt resistor element 15 being between the busbars 3 and 5, a step is introduced between the two busbars 3 and 5.

In contrast to the above, the embodiment depicted in Figure 11 produces no step in the longitudinal extension of the busbars 3 and 5. The step is prevented due to the fact that the end section 97 of busbar 3 and the end section 99 of busbar 5 are bent rectangularly with respect to the longitudinal direction 79. Thus, the end sections 97 and 99 extend perpendicular to the longitudinal direction 79.

The shunt resistor element 15 is located between the end sections 97 and 99. The end sections 97 and 99 and the shunt resistor element 15 form a sandwich structure 21. Preferably, the two busbars 3 and 5 are arranged to symmetrically mirror each other with a mirror plane extending perpendicular to the longitudinal direction 79.

The embodiment shown in Figure 11 further differs from the embodiment shown in Figure 8 in that the housing 61 is fixated to the shunt resistor element by a screw 101.

The sandwich structure 21 formed by the busbars 3 and 5 and the shunt resistor element 15 is pressed together by a screw connection 27. This screw connection 27 further fixates the housing 61, to the busbars 3 and 5, as the screw bolt 30 extends through the fixation element 83 of the housing 61. An insulation structure 37 is arranged between the screw bolt 30 and the components of the sandwich structure 21 in order to make sure that the electric current flowing between the busbars 3 and 5 flows through the shunt resistor element 15.

An arrangement as described above, in which the shunt resistor element 15 is arranged between bent end sections 97 and 99 of the busbars 3 and 5, is basically possible for all embodiments described before with respect to Figures 1 to 10.

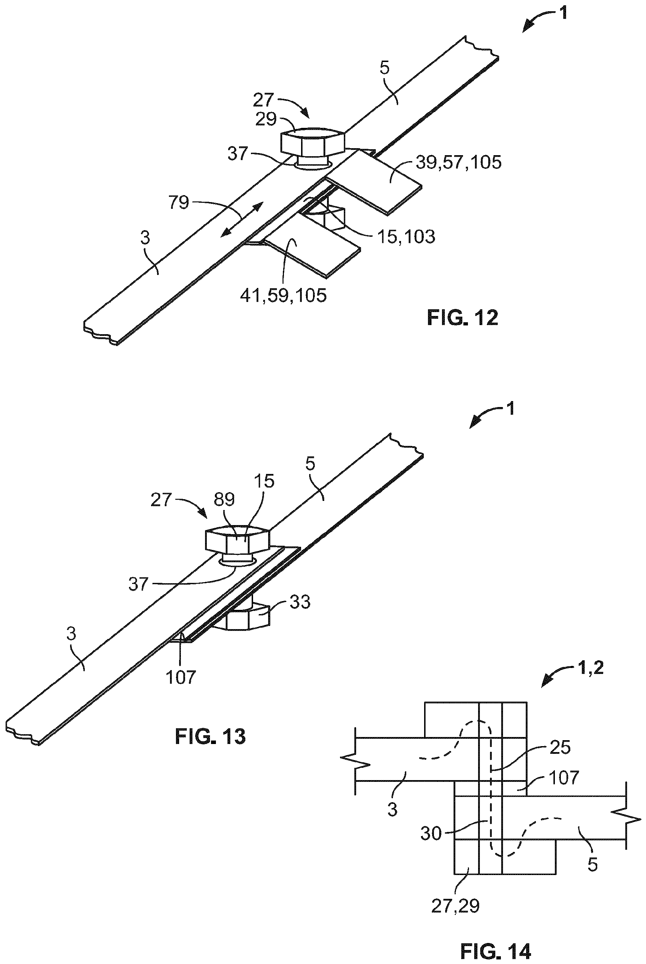

In the following, three further embodiments of the busbar assembly 1 are described with respect to Figures 12 to 15. As before, only the differences to the embodiments described are mentioned in detail.

The three embodiments are exemplarily described with respect to arrangements in which the busbars 3 and 5 extend continuously along the longitudinal direction 79. As an alternative , the busbars 3 and 5 could be provided with bent end sections 97 and 99.

The shunt resistor element 15 of the embodiment shown in Figure 12 may be formed as a sheet 103 made from a material that is suitable to be used as a shunt resistor element 15.

Alternatively, the shunt resistor element 15 may be formed as a foil or a washer. The sheet 103 is preferably made from a material comprising manganese, such as a copper alloy comprising manganese.

An insulation structure 37 is provided and configured to electrically insulate the screw 29 from the busbars 3 and 5 and the shunt resistor element 15.

The measurement contact 39 is preferably monolithically formed with electric connection line 57 and extends as a foil 105 between the first busbar 3 and the shunt resistor element 15.

Similarly, the second measurement contact 41 is formed monolithically with the electric connection line 59 as a foil 105.

The foils 105 may be made from copper or an alloy containing copper. As in the other embodiments, a screw connection 27 is provided to fixate the shunt resistor element 15 between the busbars 3 and 5.

The foils 105 may be pressed between the shunt resistor element 15 and the corresponding busbar 3 or 5 by the screw connection 27.

Alternatively, the foils 105 may be fixated on the shunt resistor element 15 before assembling the assembly 1, for example by gluing, welding or soldering.

The foils 105 may cover the corresponding side of the shunt resistor element 15 completely or only in parts. The shunt resistor element 15 and the foils 105 may form a three-layer sandwich structure that can be arranged between the two busbars 3 and 5.

In the embodiment shown in Figure 13, the screw 29 of the screw connection 27 is configured as shunt resistor element 15.

Thus, the screw 29 is preferably made from a material containing manganese, in particular a copper alloy containing manganese.

In order to provide a current flow through the screw 29, an insulating layer 107 is arranged between the two busbars 3 and 5.

The insulating layer 107 may be a washer, a foil or a coating on at least one of the busbars 3 or 5.

Figure 14 shows the current flow direction 25 of the assembly 1 described with respect to Figure 13 in a simple sketch.

The current flows from one of the busbars 3 or 5 into the corresponding head or nut of the screw 29, through the screw bolt into the opposite head 89 or nut 33 and from there into the other busbar 3 or 5.

An insulation structure 37 may be provided between the screw bolt 30 and the busbars 3 and 5 in order to assure that the current flows from the busbars into the corresponding screw head 89 or nut 33, taking advantage of a larger contact area.

Between the screw head 89 or nut 33 and the corresponding busbar 3 or 5, additional washers, such as washers made from copper or a material containing manganese may be provided.

Electrical measurement contacts (not shown here) may be electrically contacted to the screw nut 33 and screw head 89.

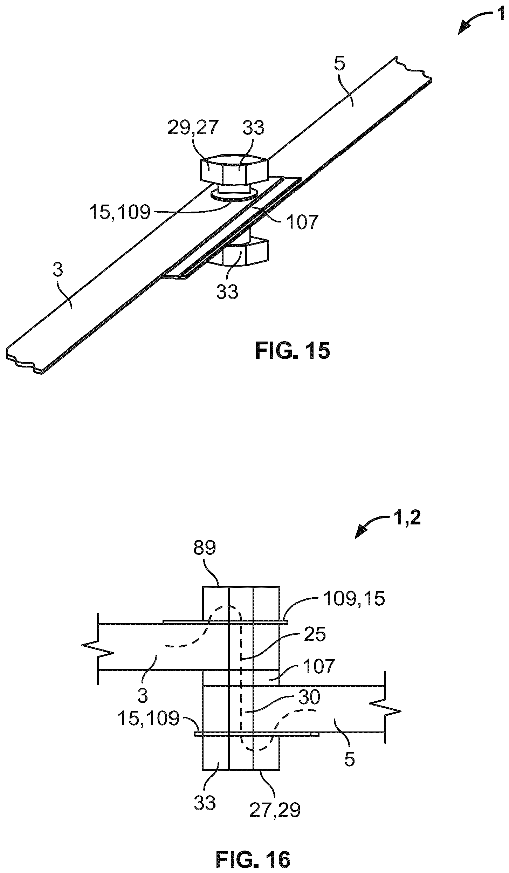

The embodiment shown in Figure 15 differs from the embodiment shown in Figure 13 in that at least one washer 109 that is arranged between one of the busbars 3 or 5 and a screw head 89 or screw nut 33 is configured as a shunt resistor element 15.

The current flow direction 25 of this embodiment is depicted in Figure 16. The current may flow from one of the busbars 3 or 5 through one of the washers 109 into the corresponding screw head 89 or screw nut 33. From there, the current may flow through the screw bolt 30 into the opposite screw head 89 or nut 33 and finally into the other busbar 3 or 5.

At this location, a second washer 109 may be present, but this is not mandatory.

The washers 109 acting as shunt resistor elements 15 may be provided with the necessary measurement contacts 39 and 41, which are not shown here.

Further, not shown in Figures 15 and 16 is an insulation structure 37 , which ensures that the electric current does not directly flow from one of the busbars 3 or 5 into the screw bolt 30.

The arrangement of the screw nut 33 and the screw head 89 is merely exemplary and could be arranged vice versa in all embodiments described above.

### REFERENCE NUMERALS

- 1: busbar assembly
- 2: assembled state
- 3: first busbar
- 5: second busbar
- 7: flat side of the first busbar
- 9: second flat side of first busbar
- 11: first flat side of second busbar
- 13: second flat side of second busbar
- 15: shunt resistor element
- 17: first flat side of shunt resistor element
- 19: second flat side of shunt resistor element
- 21: sandwich structure
- 23: direction
- 25: current flow direction
- 27: screw connection
- 29: screw
- 30: screw bolt
- 31: bottom plate
- 33: screw nut
- 35: washer
- 37: insulation structure
- 39, 41: measurement contacts
- 42: washer
- 43: inner side of through-holes
- 45: through-hole
- 49, 51: step
- 53: through-hole
- 55: through-hole
- 57, 59: electric connection lines
- 61: housing
- 63: circuit board
- 65, 67: receptacle
- 69: receiving channel
- 71: plug element
- 73, 75: contact springs
- 77: groove
- 79: longitudinal direction
- 81: groove
- 83: fixation element
- 85, 87: insulating washers
- 89: screw head
- 91: additional measurement contact
- 93: additional electrical connection line
- 95: electrically conductive washer
- 97, 99: end section
- 101: screw
- 103: sheet
- 105: foil
- 107: insulating layer
- 109: washer

## Claims

1. Busbar assembly (1) configured to measure an electric current between two busbars (3, 5), the busbar assembly (1) comprising a first busbar (3) with at least one flat side (7, 9), a second busbar (5) and a shunt resistor element (15), wherein, in an assembled state (2), the shunt resistor element (15) abuts the flat side (7, 9) of the first busbar (3) and is in electrical contact with the second busbar (5).

2. Busbar assembly (1) according to claim 1, wherein, in the assembled state (2), the first busbar (3), the second busbar (5) and the shunt resistor element (15) overlap in a direction (23) perpendicular to the flat side (7) of the first busbar (3).

3. Busbar assembly (1) according to claim 1 or 2, wherein the busbar assembly (1) has a current flow direction (25) extending through the shunt resistor element (15) perpendicular to the flat side (7, 9) of the first busbar (3).

4. Busbar assembly (1) according to any one of claims 1 to 3, wherein the second busbar (5) has at least one flat side (11, 13) and wherein the shunt resistor element (15) abuts the flat side (11, 13) of the second busbar (5) in the assembled state (2).

5. Busbar assembly (1) according to any one of claims 1 to 4, wherein the first busbar (3), the second busbar (5) and the shunt resistor element (15) form a sandwich structure (21) in the assembled state (2).

6. Busbar assembly (1) according to any one of claims 1 to 5, wherein the shunt resistor element (15) has an overall disk shape.

7. Busbar assembly (1) according to any one of claims 1 to 6, wherein the shunt resistor element (15) has a ring shape.

8. Busbar assembly (1) according to any one of claims 1 to 7, wherein, in the assembled state (2), the shunt resistor element (15) is connected via at least one screw connection (27) to at least one of the busbars (3, 5).

9. Busbar assembly (1) according to claim 8, wherein, in the assembled state (2), a screw bolt (30) extends through the first busbar (3), the second busbar (5) and the shunt resistor element (15).

10. Busbar assembly (1) according to any one of claims 1 to 9, wherein, in the assembled state (2), the shunt resistor element (15) is connected via at least one weld connection to at least one of the busbars (3, 5).

11. Busbar assembly (1) according to any one of claims 1 to 10, wherein at least one measurement contact (39, 41) is embedded in the shunt resistor element (15).

12. Busbar assembly (1) according to any one of claims 1 to 11, wherein at least one measurement contact (39, 41) abuts the shunt resistor element (15) in the assembled state (2).

13. Busbar assembly (1) according to any one of claims 1 to 12, wherein at least one measurement contact (15) is in electrical contact with one of the busbars (3, 5), at the same electric potential as the shunt resistor element (15).

14. Busbar assembly (1) according to any one of claims 1 to 13, wherein at least one measurement contact (39, 41) is configured as a washer (42) and located between the shunt resistor element (15) and at least one of the busbars (3, 5) in the assembled state (2).

15. Busbar assembly (1) according to any one of claims 1 to 14, wherein the shunt resistor element (15) comprises manganese.
